**Europäisches Patentamt**

**European Patent Office**

**Office européen des brevets**

(19)

(11) Veröffentlichungsnummer: **0 355 197**

**A1**

(12) ## EUROPÄISCHE PATENTANMELDUNG

(21) Anmeldenummer: **88113986.9**

(22) Anmeldetag: **26.08.88**

(51) Int. Cl.⁴: **G01R 19/14**

(43) Veröffentlichungstag der Anmeldung:
**28.02.90 Patentblatt 90/09**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Steinel, Heinrich W.**
**Röntgenweg 8**
**D-8939 Bad Wörishofen(DE)**
Erfinder: **Armonier, Ulrich**
**Havelstrasse 3a**
**D-4840 Rheda-Wiedenbrück(DE)**
Erfinder: **Schulze-Fröhlich, D. F., Dr.-Ing.**
**Niggenkamp 17**
**D-4836 Herzebrock-Clarholz(DE)**

(54) **Spannungstester zur gestaffelten optischen Anzeige einer Spannung und Verfahren zur Herstellung eines solchen Spannungstesters.**

(57) Es wird ein Spannungstester zur gestaffelten Anzeige einer Spannung (U) an zwei Prüfspitzen (1, 2) vorgeschlagen, dessen Schaltungsanordnung aus einer Parallelschaltung dreier Reihenschaltungen (I, II, III) besteht, wobei in zwei Reihenschaltungen (I, II) je ein Kaltleiter (PTC-Resistor), eine Antiparallelschaltung zweier Leuchtdioden (4, 5, 9, 10) und Vorwiderstände (6, 7, 13, 14) enthalten sind, in der zweiten Reihenschaltung (II) sind zusätzlich zwei gegeneinander geschaltete Zenerdioden (11, 12) enthalten und die dritte Reihenschaltung (III) besteht aus einer Glimmlampe (15) und Vorwiderständen (16, 17). Die Bauelemente des Spannungstester sind in einem Griff untergebracht, der über ein Leitungskabel (21) mit einem zweiten Griff verbunden ist, in welchem sich ein Strombegrenzungswiderstand (18) befindet. Es werden bevorzugte Ausführungen dieses Spannungstesters und ein bevorzugtes Verfahren zu seiner Herstellung vorgeschlagen.

FIG 1

## Spannungstester zur gestaffelten optischen Anzeige einer Spannung und Verfahren zur Herstellung eines solchen Spannungstesters

Die Erfindung betrifft einen Spannungstester zur gestaffelten optischen Anzeige der an Prüfspitzen anliegenden Spannung mit einer Schaltungsanordnung der elektrischen Bauelemente, die eine erste Reihenschaltung aus einem ersten Kaltleiter, zwei antiparallel geschalteten Leuchtdioden und wenigstens einen Vorwiderstand enthält, die so abgestimmt ist, daß bei einer Spannung an den Prüfspitzen, die 4,5 V, insbesondere 6 V, übersteigt, eine oder beide Leuchtdioden aufleuchten.

Die Erfindung betrifft insbesondere einen derartigen Spannungstester, bei dem die einzelnen elektrischen und mit Stromzuführungsdrähten versehenen Bauelemente der gesamten Schaltungsanordnung in einem aus zwei Griffen bestehenden Gerät untergebracht sind, die durch ein Verbindungskabel miteinander verbunden sind, Prüfspitzen aufweisen und Öffnungen enthalten, durch die hindurch die zur optischen Anzeige dienenden Bauelemente beobachtet werden können.

Die Erfindung betrifft ferner ein Verfahren zur Herstellung eines derartigen Spannungstesters.

·In der DE-PS 20 60 884 ist eine Prüfeinrichtung zum Anzeigen der Polarität bzw. der Phasenlage von elektrischen Potentialen gegenüber einem vorgegebenen Bezugspotential, insbesondere für ein periodisch zwischen zwei Potentialen wechselndes Bezugspotential in Schaltwerken mit ambivalenten Schaltvariablen in Form des Bezugspotentials, deren Werte sich durch einen Phasenunterschied von 180° unterscheiden, beschrieben, bei der eine Reihenschaltung aus zwei antiparallel geschalteten Leuchtdioden und einem vorgeschalteten Strombegrenzungswiderstand verwendet ist. Die beiden Leuchtdioden sind dabei in mindestens einer Öffnung eines griffelförmigen Gehäuses geschützt angeordnet, das gleichzeitig den Strombegrenzungswiderstand enthält und an einer Stirnseite eine Metallspitze trägt. Das griffelförmige Gehäuse kann eine längliche Öffnung aufweisen, die durch ein lichtdurchlässiges Material abgedeckt ist, hinter dem die beiden Leuchtdioden geschützt mit ihrer Lichtaustrittsseite nach außen weisend hintereinander angeordnet sind. Das griffelförmige Gehäuse trägt an einem Ende ein Teil der elektrischen Steckverbindung zur Aufnahme des entsprechenden anderen Teils mit einer Prüfleitung.

In der US-PS 4 210 862 ist die beschriebene Prüfeinrichtung dahingehend weitergebildet, daß durch Anwendung einer zusätzlichen Schaltung mit Batterie auch auf Stromdurchgang durch eine Leitung geprüft werden kann. Alle Bauelemente dieses Gerätes sind in einem Griff untergebracht, das mit einer Prüfspitze versehen und mit einem zweiten Griff über ein Kabel verbunden ist, der ebenfalls eine Prüfspitze aufweist.

Die Antiparallelschaltung der beiden Leuchtdioden bewirkt, daß bei einer an den Prüfspitzen anliegenden Gleichspannung nur jeweils die auf Durchlaß geschaltete Leuchtdiode aufleuchtet, während die andere Leuchtdiode sperrt. Welche der beiden Leuchtdioden bei Gleichspannung aufleuchtet, hängt davon ab, welcher Pol der Gleichspannungsquelle mit der zugehörigen Prüfspitze verbunden ist. Bei einer Wechselspannung an den Prüfspitzen leuchten logischerweise beide Leuchtdioden auf.

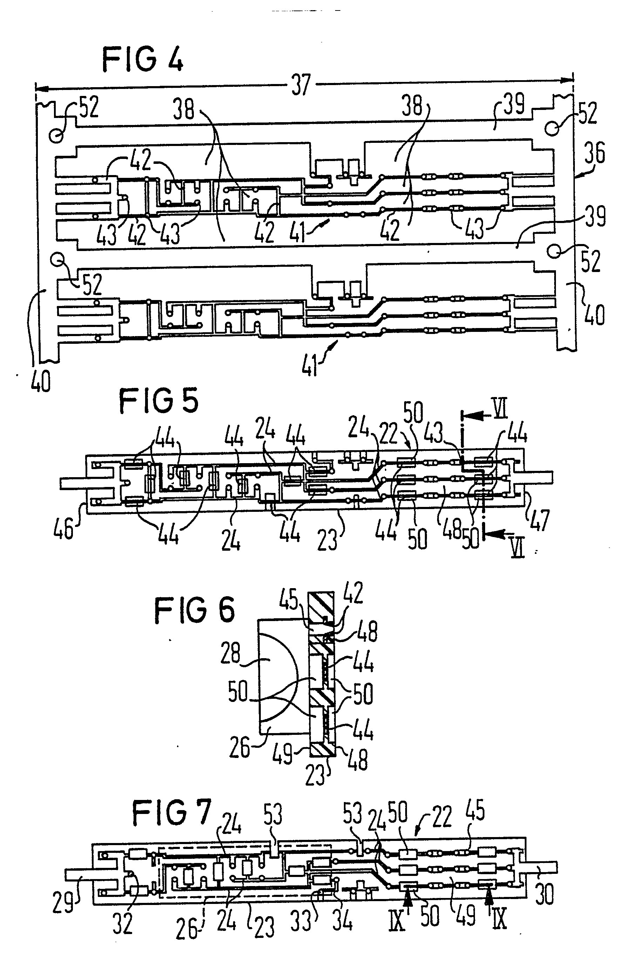

In der EP-B 0 011 711 (entsprechend der US-PS 4 301 407) ist eine Prüfeinrichtung zum stufenweisen Anzeigen einer Meßspannung beschrieben, die zwei mit Kontaktspitzen versehene Griffe umfaßt, die durch ein Kabel verbunden sind und von denen eine eine Anzeigeeinheit enthält, die eine Reihenschaltung aus nichtlinearen Leuchtelementen sowie einen Spannungsteiler aus mehreren in Reihe geschalteten Widerständen enthält, der von der Meßspannung beaufschlagt ist, wobei jeweils an jeden der von den Verbindungspunkten der Widerstände gebildeten Abgriffe des Spannungsteilers die Basis je eines Transistors angeschlossen ist, dessen Emitter jeweils mit der einen Klemme je eines der Leuchtelemente und dessen Kollektor jeweils mit den Kollektoren der übrigen Transistoren sowie mit einer Klemme einer Stromversorgung verbunden ist, deren andere Klemme an die andere Klemme des Leuchtelementes am Ende der Reihenschaltung angeschlossen ist. In FIG 4 dieser Patentschrift und in der zugehörigen Beschreibung ist eine Schaltung vorgesehen, bei der neben einer Antiparallelschaltung zweier Leuchtdioden, die mit einem Kaltleiter in Reihe geschaltet ist, sowohl weitere Leuchtdioden, als auch Glimmlampen enthalten sind.

Diese Prüfeinrichtungen weisen für die praktische Anwendung eine Reihe erheblicher Vorteile auf, die unter anderem darin bestehen, daß die zu prüfende Spannung in sehr viele Spannungsbereiche unterteilt gestaffelt angezeigt werden kann, beispielsweise jeweils beginnende Bereiche bei 6 V, 12 V, 24 V, 50 V, 110 V, 220 V, 380 V, 600 V. Dennoch ist der Aufwand sowohl im Hinblick auf die notwendigen elektrischen Bauelemente als auch im Hinblick auf die Herstellung sowohl der die Bauelemente tragenden Platine mit gedruckten Leiterbahnen als auch auf die Bestückung derselben mit den elektrischen Bauelementen sehr groß.

In der EP-B 0 068 501 (entsprechend der US-PS 4 527 118) ist eine nochmals verbesserte Prüfeinrichtung der eben beschriebenen Art beschrieben, die zusätzlich zu der bisherigen gestaffelten Anzeige der zu bestimmenden Spannung auch noch die Möglichkeiten enthält, eine elektrische Leitung auf Stromdurchgang zu prüfen (wofür eine Batterie enthalten ist), einen Funktionstest der einzelnen Bauelemente durchzuführen und durch Vorschaltung eines hochohmigen Vorwiderstandes und einem zuschaltbaren, aus mehreren Kaltleitern und normalen Widerständen bestehenden Lastwiderstandskreis Spannungsquellen mit hohem Innenwiderstand, also nicht Netzspannungsquellen, zu identifizieren.

Wenigstens ein hochohmiger Vorwiderstand und dieser Lastwiderstandskreis sind in einem der beiden durch ein Kabel verbundenen Griffe der Prüfeinrichtung untergebracht.

Die bisher beschriebenen Prüfeinrichtungen haben wegen ihrer Vorteile in der Praxis mit sehr hohen Stückzahlen Eingang gefunden.

Es hat sich aber auch gezeigt, daß für viele Anwendungsfälle eine geringere Staffelung der einzelnen Anzeigebereiche für die zu bestimmende Spannung ausreicht, beispielsweise nämlich ab 4,5 V, ab 50 V und ab 110 V. Während die ersten beiden Spannungsbereiche noch relativ ungefährlich für den den Spannungstester Bedienenden sind, können Spannungen ab 110 V bereits sehr gefährlich werden, insbesondere wenn 220 oder gar 380 V überschritten werden. Es reicht deshalb aus, für diesen letzten Spannungsbereich eine deutliche und gegenüber den anderen Spannungsbereichen sich abhebende optische Anzeige vorzusehen.

Es ist Aufgabe der Erfindung, einen Spannungstester anzugeben, der den vereinfachten Forderungen genügt, dabei aber im Gebrauch ausreichend für den Bedienenden abgesichert ist, eine besonders vereinfachte Schaltungsanordnung aufweist, durch die mögliche räumliche Gestaltung einfach herstellbar ist und mit wenigen elektrischen Bauelementen auskommt. Es gehört mit zur Aufgabe der Erfindung, ein Verfahren zur Herstellung eines solchen Spannungstesters anzugeben.

Im Hinblick auf den bei dem neuen Spannungstester zu verwendenden Systemträger wird auf die DE-OS 31 48 382 hingewiesen, in der ein Elektrogerät, insbesondere ein Elektrowerkzeug, mit steckbaren Bauteilen und einer Verbindungsplatte zum Anstecken und Verbinden der Bauteile untereinander und/oder mit der Stromzuführung beschrieben ist, bei dem die Verbindungsplatte ein Netzwerk aus leitenden Metallstreifen oder -drähten aufweist, das in Kunststoff eingebettet ist. Elektrische Bauelemente, wie z.B. elektrische Widerstände, Leuchtdioden, Zenerdioden oder Kaltleiter werden auf diese Verbindungsplatte nicht aufgebracht, so daß diese bekannte Verbindungsplatte als Systemträger im Sinne der vorliegenden Erfindung nicht in Frage kommt.

Zur Lösung der der Erfindung zugrundeliegenden Aufgabe ist der Spannungstester der eingangs angegebenen Art erfindungsgemäß gekennzeichnet durch die weiteren Merkmale:

- parallel zur ersten Reihenschaltung ist wenigstens eine zweite Reihenschaltung aus einem zweiten Kaltleiter, zwei antiparallel geschalteten Leuchtdioden, zwei in Reihe liegenden, jedoch gegeneinander gepolten Zenerdioden und wenigstens einem Vorwiderstand geschaltet, die so abgestimmt ist, daß bei einer Spannung an den Prüfspitzen, die 40 V, insbesondere 50 V, übersteigt, eine oder beide Leuchtdioden aufleuchten;
- parallel zur ersten Reihenschaltung und zur wenigstens einen zweiten Reihenschaltung ist eine dritte Reihenschaltung aus einer Glimmlampe und wenigstens einem Vorwiderstand geschaltet, die so abgestimmt ist, daß bei einer Spannung an den Prüfspitzen, die 110 V, insbesondere 120 V, übersteigt, die Glimmlampe aufleuchtet;
- in Reihe zu den drei Reihenschaltungen ist ein Strombegrenzungswiderstand geschaltet.

Ein bevorzugter Spannungstester ist durch folgende Merkmale gekennzeichnet:
- in der ersten Reihenschaltung weist der erste Kaltleiter einen Widerstandwert von 3,2 bis 4,6 kOhm auf, die Leuchtdioden sind für das Aufleuchten bei 4,5 V, insbesondere 6 V, ausgelegt und es sind zwei Vorwiderstände vorhanden, die je einen Widerstandswert von 1 kOhm bei einer Leistung von 1 W aufweisen;
- in der zweiten Reihenschaltung weist der zweite Kaltleiter einen Widerstandswert von 3,2 bis 4,6 kOhm auf, die Leuchtdioden sind für das Aufleuchten bei 40 V, insbesondere 50 V, ausgelegt, es sind zwei Vorwiderstände vorhanden, die je einen Widerstandswert von 1 kOhm bei einer Leistung von 1 W aufweisen, und die beiden Zenerdioden haben eine Durchbruchspannung von 35 bis 40 V;
- in der dritten Reihenschaltung sind zwei Vorwiderstände vorhanden, die je einen Widerstandswert von 75 kOhm bei einer Leistung von 1 W aufweisen, und die Glimmlampe ist für das Aufleuchten bei 110 V, insbesondere 120 V, ausgelegt;
- der Strombegrenzungswiderstand weist einen Widerstandswert von 220 Ohm bei einer Leistung von 1 W auf.

Eine bevorzugte Ausführungsform dieses Spannungstesters mit den eingangs schon angegebenen Merkmalen ist erfindungsgemäß gekennzeichnet durch die Merkmale:
- der Strombegrenzungswiderstand ist in einem Griff untergebracht;
- die restlichen elektrischen Bauelemente der drei Reihenschaltungen sind im anderen Griff untergebracht, befinden sich dort auf einem dem Hohlraum des Griffes angepaßten Systemträger und sind miteinander durch aus Metallblech bestehende Leitungen elektrisch leitend verbunden;

- der Systemträger besteht aus einer einstückigen, längsgestreckten Isolierstoffumhüllung, in der die die Bauelemente verbindenden Leitungen derart eingebettet sind, daß sie nur an Lötstellen die untere Oberflächenseite der Isolierstoffumhüllung durchstoßen;

- die Isolierstoffumhüllung ist einstückig mit einem Aufsatz versehen, der runde Ausnehmungen, in denen die Leuchtdioden untergebracht sind, und eine längliche Ausnehmung, in der die Glimmlampe untergebracht ist, enthält;

- der Systemträger weist an den gegenüberliegenden Enden Anschlußfahnen auf, die aus der Isolierstoffumhüllung herausragen, mit denen im Inneren der Isolierstoffumhüllung die Schaltungsanordnung des zweiten Griffes verschaltet ist und von denen eine Anschlußfahne mit der Prüfspitze und die andere Anschlußfahne mit dem Verbindungskabel verbunden ist.

Bei diesem Spannungstester ist es vorteilhaft, wenn ein Leitungskabel vorhanden ist, durch das die Glimmlampe mit der An schlußfahne verbunden ist und das von einem Lötpunkt der Anschlußfahne ausgehend an dem Aufsatz der Isolierstoffumhüllung entlanggeführt zu einem Lötpunkt einer eingebetteten Verbindungsleitung verläuft, die mit einem Pol der Glimmlampe verbunden ist.

Das Kabel kann selbstverständlich auch durch eine gestanzte Leiterbahn ersetzt sein. '

Eine besonders einfache Ausführungsform des Spannungstesters ist erfindungsgemäß dadurch gekennzeichnet, daß die Bauelemente auf der oberen Oberflächenseite des Systemträgers wie folgt angeordnet sind:

- die beiden Kaltleiter befinden sich in Längsrichtung des Systemträgers an seinem vorderen Ende parallel zueinander;

- zwischen den beiden Kaltleitern beginnt das Leitungskabel, verläuft dann entsprechend oft rechtwinklig abgebogen an der Außenseite des Aufsatzes zu einem Lötpunkt;

- die Leuchtdioden sind in einer Reihe in Längsrichtung des Systemträgers und in dessen Mitte in den runden Ausnehmungen des Aufsatzes untergebracht;

- die Glimmlampe befindet sich in der länglichen Ausnehmung des Aufsatzes anschließend an die letzte der Leuchtdioden;

- die Zenerdioden sind im Anschluß an die Glimmlampe quer zur Längsrichtung des Systemträgers angeordnet;

- die Vorwiderstände der ersten Reihenschaltung sind hintereinander und in Längsrichtung des Systemträgers in Nachbarschaft zu einem Rand der Oberflächenseite angeordnet;

- die Vorwiderstände der zweiten Reihenschaltung sind parallel zu den Vorwiderständen der ersten Reihenschaltung in Nachbarschaft zum anderen Rand der Oberflächenseite angeordnet;

- die Vorwiderstände der dritten Reihenschaltung sind parallel zu den anderen Vorwiderständen und zwischen denselben angeordnet.

Das Verfahren zur Herstellung eines solchen Spannungstesters ist erfindungsgemäß gekennzeichnet durch die nachfolgenden Verfahrensschritte in dieser oder in einer entsprechenden Reihenfolge:

a) aus einem mit einer lötfähigen Schicht überzogenen, 0,1 bis 1,0 mm dicken Metallblechband beliebiger Länge und einer Breite, die größer als das ganzzahlige Ein- bis Fünffache der Länge eines Systemträgers samt Anschlußfahnen ist, werden sämtliche Zwischenräume zwischen Restverbindungen verbleibender Randstreifen des Metallblechbandes und einer Anordnung aus Metallstreifen und zwischen diesen Metallstreifen derart herausgestanzt, daß die Metallstreifen dieser Anordnung dem späteren Bild der Leitungen des Systemträgers entsprechen und Kontaktlöcher für die Stromzuführungsdrähte der Bauelemente aufweisen;

b) das ausgestanzte selbsttragende Metallblechband wird einem Werkzeug zur Spritzguß- oder Gießformumhüllung zugeführt, wo jede der Anordnungen zumindest einzeln in Isolierstoff eingebettet wird, der nach der Aushärtung· die Isolierstoffumhüllung mit dem Ansatz bildet, wobei die Anschlußfahnen an den Enden herausragen;

c) das derart vorbehandelte Metallblechband wird einem weiteren Stanzwerkzeug zugeführt, bei dem aus den Metallstreifen diejenigen Teile entfernt werden, die vorher zum Zusammenhalt des gestanzten Metallblechbandes, nicht aber nachher für die Verschaltung der elektrischen Bauelemente im späteren Bild der Leitung des Systemträgers notwendig sind, und bei dem ferner in der Isolierstoffumhüllung im Bereich der Kontaktlöcher Öffnungen erzeugt werden und die die Kontaktlöcher umgebenden Teile der Metallstreifen zur unteren Oberflächenseite der Isolierstoffumhüllung gedrückt werden;

d) vor oder nach dem Vereinzeln der Systemträger werden diese mit den elektrischen Bauelementen bestückt, die an der unteren Oberflächenseite durch Schwall- oder Tauchlötung mit den Leitungen elektrisch leitend und mechanisch verbunden werden;

e) jeder Systemträger wird in dem Hohlraum eines Griffes untergebracht, vorher oder danach werden die Anschlußfahnen mit der Prüfspitze bzw. mit dem Verbindungskabel, das bereits am anderen Griff angebracht ist und den Strombegrenzungswiderstand enthält, verbunden, wonach der Griff verschlossen wird.

Vorzugsweise wird die im Verfahrensschritt c) vorgesehene Maßnahme, bei der die die Kontaktlöcher umgebenden Teile der Metallstreifen aus deren Ebene heraus in Richtung der unteren Oberflächenseite der Isolierstoffumhüllung gedrückt werden, bereits im Verfahrensschritt a) zusammen mit dem dortigen Stanzwerkzeug durchgeführt.

Ferner ist es vorteilhaft, wenn im Verfahrensschritt b) bei der Herstellung der Isolierstoffumhüllung in der Spritzgußform oder in der Gießform Erhebungen vorgesehen sind derart, daß sowohl die Öffnungen im Bereich der Kontaktlöcher als auch von einer oder von beiden Oberflächenseiten der Isolierstoffumhüllung aus Vertiefungen entstehen, die bis zu den zu entfernenden Teilen der Metallstreifen reichen.

Die Grundlage für dieses Verfahren ist ein durch Ätzen oder Stanzen bearbeitetes Metallblechband, welches alle notwendigen Verbindungen enthält, das aber durch zusätzliche Teile in den einzelnen Leitungen noch zusammenhält. Ein solches Metallblechband kann auf einer schnell laufenden Stanzeinrichtung in großen Stückzahlen am laufenden Band extrem preiswert hergestellt werden.

Nach diesem Vorgang wird das Metallblechband einem Spritzwerkzeug für thermoplastische Kunststoffe zugeführt und mit einem Kunststoffmaterial umspritzt, beispielsweise mit gefülltem oder ungefülltem Epoxidharz umspritzt oder, bei Verwendung von Gießformen, umgossen. Dieses Spritzwerkzeug kann als Mehrfachwerkzeug ausgelegt sein, damit bei einem Spritzvorgang eine bzw. mehrere Leiterbahnanordnungen das Spritzwerkzeug verlassen. In einem weiteren Arbeitsgang werden dann alle Verbindungen ausgestanzt, die vorher als Halterungen für das gestanzte Band dienten, aber für die spätere elektrische Funktion nicht vorhanden sein dürfen.

Nach diesem Stanzvorgang erfolgt die Bestückung der Systemträger mit den elektrischen Bauelementen und die Verlötung der Stromzuführungen der Bauelemente mit den die Kontaktlöcher umgebenden Metallteilen. Danach werden an die Anschlußfahnen einerseits die Prüfspitze und andererseits das Verbindungskabel angelötet oder angeschweißt. Bis zu diesem Fertigungszeitpunkt können die fertigen Systemträger noch mit dem durch die Restverbindungen und die verbleibenden Reststreifen gehaltenen Teile des Metallblechbandes verbunden bleiben, wodurch eine besonders einfache Massenfertigung resultiert.

Danach werden die fertigen Systemträger vereinzelt und im Hohlraum des jeweiligen Griffes des Gerätes untergebracht.

Die Erfindung gewährleistet eine Reihe von Vorteilen.

Fertigungstechnische Vorteile:

Vom Metallblechband bis zur Vereinzelung der fertigen Spannungstester ist der Transport automatisch ohne Ablage von Teilen und neuer Aufnahme gewährleistet. Die Führung ist durch die Geometrie des gestanzten Metallblechbandes zwangsläufig und so präzise wie das gestanzte Metallblechband selbst.

Es ist kein anderes Fertigungsverfahren in der Elektronik für die Herstellung solcher Geräte bekannt, das eine Aussage mit derartigen Vorteilen einer Endlosfertigung zuläßt.

Elektrische Vorteile:

Nach den geltenden Sicherheits-Vorschriften, z.B. den VDE-Vorschriften in der Bundesrepublik Deutschland, kann der durch die Erfindung vorgeschlagene Spannungstester mit einer konventionellen Platine mit gedruckten Leiterbahnen aufgrund der zu geringen Leiterbahnabstände und der ungenügenden Luft- und/oder Kriechstrecke nicht kostengünstig gefertigt werden. Es ist nämlich das Vergießen der gesamten Schaltung (Platine + Leiterbahnen) nach deren Fertigstellung erforderlich. Diese Vorgehensweise ist aber für eine Massenfertigung nicht geeignet und aufgrund der Verwendung von Vergußmassen und deren Lösungsmitteln nicht akzeptabel.

Die Erfindung ermöglicht ein vollständiges Umspritzen der Leiterbahnen und somit eine sehr hohe Isolationsklasse. Die notwendigen Kontaktlöcher oder Öffnungen im Isolierstoff im Bereich der Kontaktlöcher lassen sich konstruktiv so gestalten, daß alle Sicherheitsforderungen bezüglich Luft- und Kriechstrecken erfüllt sind. In besonders kritischen Bereichen kann in das umschließende Gehäuse des Griffes eine Wand konstruktiv so eingesetzt werden, daß sie beim Gehäusezusammenbau durch die Öffnungen und Kontaktlöcher hindurchtritt und damit die Luftstrecke vergrößert. Sind die Leiterabstände in horizontaler Richtung zu klein, so können die Leiterbahnen z.T. oder insgesamt senkrecht gestellt werden, um die Mindestabstände wiederherzustellen.

Mechanische Vorteile:

Der Werkstoff für die Kunststoffummantelung bei der Herstellung des Systemträgers läßt sich mit allen Fertigungshilfen für die Montage versehen, ohne daß - wie bisher - Extrateile eingesetzt werden müssen. Falls die notwendigen Lötstellen in ihrer Position die Luft- und Kriechstrecken unterschreiten, kann mit gespritzten Trennstäben Abhilfe geschaffen werden, die an die einzelnen Positionen gebracht werden. Bei einer konventionellen Platine mit gedruckten Leiterbahnen wäre hier Vergußmasse nötig.

Schaltungsmäßige Vorteile:

Die Schaltung ist äußerst einfach und wird dennoch allen Sicherheitsforderungen gerecht. Es wird vollständig auf Transistoren verzichtet. Durch diese Einfachheit der Schaltung kann ein Spannungstester hergestellt werden, bei dessen Zusammenbau keine besonderen Vorkehrungen nötig sind, denn die einzelnen elektrischen Bauelemente, Kaltleiter, Leuchtdioden, Glimmlampen, Zenerdioden und Vorwiderstände, sind je für sich unterscheidbar zu erkennen und können nicht an falschen Stellen eingebaut werden.

Die Einfachheit gibt aber auch die Möglichkeit, die Anordnung der Leiterbahnen so einfach zu gestalten, daß einerseits dieselben aus einem Metallblech ausgestanzt werden können, ohne daß Überkreuzungen nötig sind und wobei gleichzeitig eine Fördereinrichtung für eine Reihe weiterer Verfahrensschritte vorhanden ist. Andererseits ist eine einfache Umhüllung und eine besonders einfache Anordnung der einzelnen Bauelemente möglich.

Die Erfindung wird nachfolgend anhand der beigefügten Figuren näher erläutert.

Es zeigen:

FIG 1 das Schaltbild für die Schaltungsanordnung;

FIG 2 den Spannungstester als Gerät, das aus zwei durch ein Kabel miteinander verbunden Griffen besteht;

FIG 3 eine Seitenansicht gemäß Pfeil III in FIG 8 des bestückten Systemträgers;

FIG 4 zwei Leiterbahnanordnungen, die bereits aus einem Metallblechband ausgestanzt sind;

FIG 5 zur Vereinfachung einzeln dargestellt die Anordnung der Leiterbahnen unter Darstellung der zu entfernenden Leiterbahnteile;

FIG 6 einen Schnitt durch FIG 5 gemäß der Linie VI - VI;

FIG 7 eine Draufsicht auf die Oberseite des umspritzten Isolierstoffträgers, bei dem die zu entfernenden Teile bereits nicht mehr vorhanden sind;

FIG 8 den Spannungstester in Draufsicht, wobei in dem einen Griff der bestückte Isolierstoffträger gemäß Pfeil VIII in FIG 3 gezeigt ist;

FIG 9 den Ausschnitt IX in FIG 3 als Schnitt längs der Linie IX - IX in FIG 7 und 8 in vergrößerter Darstellung.

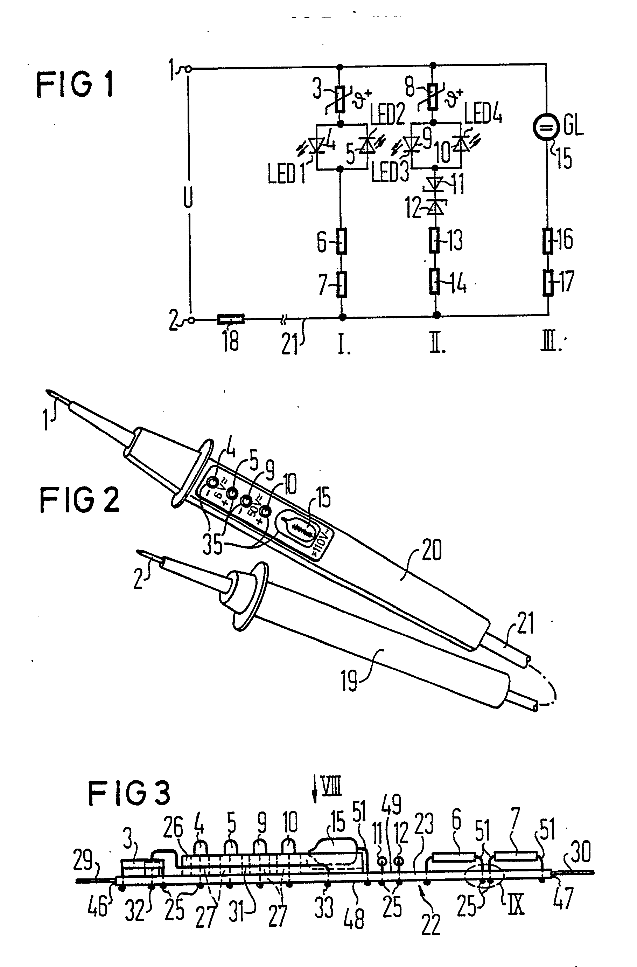

In FIG 1 ist die Schaltungsanordnung dargestellt. Zwischen den Prüfspitzen 1 und 2 liegt die anzuzeigende Spannung U.

Die Schaltungsanordnung besteht in diesem bevorzugten Ausführungsbeispiel aus den drei parallel geschalteten Reihenschaltungen I, II, III. Die Reihenschaltung I besteht aus dem Kaltleiter 3, der Antiparallelschaltung der beiden Leuchtdioden 4 (LED1) und 5 (LED2) und den beiden Vorwiderständen 6 und 7.

Die Reihenschaltung II besteht aus dem Kaltleiter 8, der Antiparallelschaltung der Leuchtdioden 9 (LED3) und 10 (LED4), den beiden gegeneinander gepolten Zenerdioden 11 und 12 und den beiden Vorwiderständen 13 und 14.

Die Reihenschaltung III besteht aus der Glimmlampe 15 (GL) und den beiden Vorwiderständen 16 und 17.

In allen drei Reihenschaltungen sind jeweils zwei Vorwiderstände gezeigt, obwohl auch nur ein Vorwiderstand mit entsprechendem Widerstandswert ausreichen würde. Die Aufteilung eines Vorwiderstandes in zwei Vorwiderstände hat im vorliegenden Zusammenhang den Zweck, einerseits den Widerstandswert genauer abstimmen zu können und andererseits eine zu starke Erwärmung der Widerstände bei starker Belastung zu vermeiden.

In der Leitung 21, die später das Verbindungskabel darstellt, ist in Reihe mit der Parallelschaltung aus den drei Reihenschaltungen I, II, III ein Strombegrenzungswiderstand 18 enthalten.

Zwischen den Reihenschaltungen II und III kann wenigstens eine weitere Reihenschaltung parallel geschaltet sein, in der durch Wahl entsprechender Zenerdioden weitere Spannungsbereiche gestaffelt angezeigt werden können.

FIG 2 zeigt den Spannungstester als Gerät, das aus den Griffen 19 und 20 besteht, die durch das Verbindungskabel 21 miteinander verbunden sind. Der Griff 19 trägt die Prüfspitze 2 und enthält in seinem Inneren den Strombegrenzungswiderstand 18.

Der Griff 20 trägt die Prüfspitze 1 und ist mit Öffnungen 35 versehen, durch die hindurch die zur optischen Anzeige dienenden Bauelemente, nämlich die Leuchtdioden 4, 5, 9, 10 und die Glimmlampe 15, beobachtet werden können.

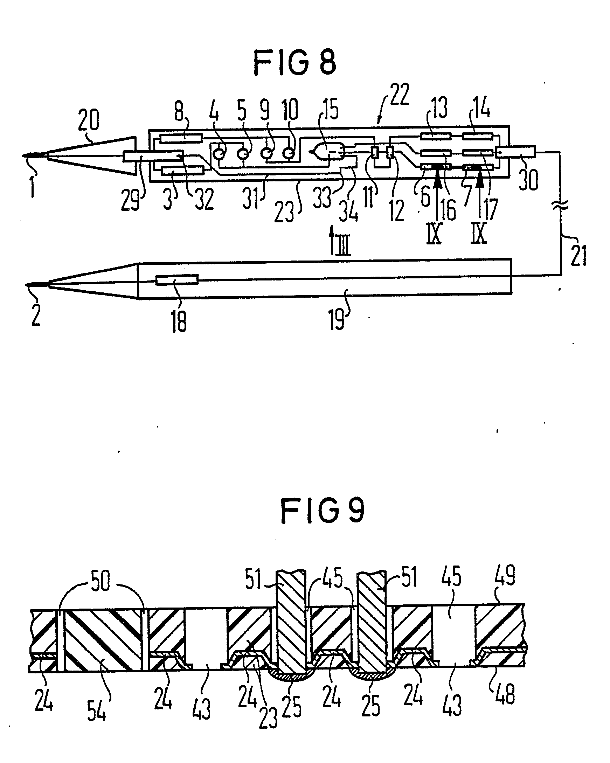

FIG 3 zeigt in Seitenansicht gemäß Pfeil III in FIG 8 den komplett bestückten Systemträger 22. Dieser Systemträger besteht aus der Isolierstoffumhüllung 23 und weist an seinem vorderen Ende 46 die Anschlußfahne 29 und an seinem hinteren Ende 47 die Anschlußfahne 30 auf, die aus der Isolierstoffumhüllung 23 herausragen.

Der Isolierstoffträger enthält ferner auf seiner oberen Oberflächenseite 49 einen Aufsatz 26, der mit vier runden Ausnehmungen 27 und einer länglichen Ausnehmung 28 versehen ist.

Man erkennt in FIG 3 den Kaltleiter 3, die Leuchtdioden 4, 5, 9 und 10, die Glimmlampe 15, die beiden Zenerdioden 11 und 12 sowie die Vorwiderstände 6 und 7.

Sämtliche Bauelemente weisen Stromzuführungsdrähte 51 auf, die durch später bei den FIG 4 bis 7 beschriebene Öffnungen 45 im Systemträger 22 hindurchreichen und auf der unteren Oberflächenseite 48 der Isolierstoffumhüllung 23 durch die Lötstellen 25 mit den in der Isolierstoffumhüllung 23 eingebetteten Leitungen 24 elektrisch verbunden sind.

Ferner ist ein Leitungskabel 31 vorhanden, das die Glimmlampe 15 mit der Anschlußfahne 29 verbindet und das von einem Lötpunkt 32 der Anschlußfahne 29 ausgehend an dem Aufsatz 26 der Isolierstoffumhüllung 23 entlanggeführt zu einem Lötpunkt 33 verläuft. Dieser Lötpunkt 33 gehört zu einer bei FIG 7 erläuterten eingebetteten Verbindungsleitung 34, die mit einem Stromzuführungsdraht 51 der Glimmlampe 15 verbunden ist.

Anhand der FIG 4 bis 8 wird das Verfahren zur Herstellung eines solchen Spannungstesters beschrieben.

In FIG 4 ist ein Metallblechband 36 gezeigt, und zwar bereits nach dem ersten Stanzvorgang. Die Breite 37 des Metallblechbandes 36 ist so gewählt, daß sie etwas größer als das ganzzahlige Ein- bis Fünffache der Länge eines Systemträgers 22 samt Anschlußfahnen 29 und 30 (vgl. FIG 5 und 7) beträgt.

Aus dem Metallblechband 36 werden zunächst sämtliche Zwischenräume 38 herausgestanzt, die zwischen Restverbindungen 39, die verbleibende Randstreifen 40 miteinander verbinden, und einer Anordnung 41 aus Metallstreifen 42 sowie zwischen diesen Metallstreifen 42 selbst vorhanden sind. Das Stanzmuster ist dabei so gestaltet, daß die Metallstreifen 42 dieser Anordnung 41 dem späteren Bild der Leitungen 24 (vgl. FIG 7) des Systemträgers 22 entsprechen und Kontaktlöcher 43 für die Stromzuführungsdrähte 51 der Bauelemente 3 bis 17 aufweisen.

In den verbleibenden Randstreifen 40 des Metallblechbandes 36 sind Löcher 52 vorhanden, die dazu dienen, daß das gleichzeitig als Transportmittel dienende Metallblechband 36 von Bearbeitungsstation zu Bearbeitungsstation transportiert werden kann.

Das in dieser Weise ausgestanzte und selbsttragende Metallblechband 36 wird danach einem Werkzeug zur Spritzguß- oder Gießformumhüllung zugeführt, wo jede der Anordnungen 41 entweder einzeln oder mehrere solcher Anordnungen 41 gleichzeitig in Isolierstoff eingebettet wird bzw. werden, der nach der Aushärtung die Isolierstoffumhüllung 23 mit einem Aufsatz 26 auf ihrer oberen Oberflächenseite 49 bildet.

In FIG 5 ist nur ein einzelner mit der Isolierstoffumhüllung 23 versehener Systemträger 22 gezeigt und zwar dort mit Blick auf seine untere Oberflächenseite 48. Die Abtrennung der einzelnen Isolierstoffträger von den verbleibenden Reststreifen 40 des Metallbandes 36 erfolgt in der Praxis vorzugsweise jedoch erst nachdem die einzelnen Systemträger mit den elektrischen Bauelementen bestückt und die Stromzuführungsdrähte 51 mit den Leitungen 24 verlötet sind und ggf. auch nachdem die Anschlußfahnen 29 und 30 mit den Zuleitungen zur Prüfspitze 1 bzw. zum Leitungskabel 21 verbunden sind.

Aus Gründen der Vereinfachung werden die nach dem Ausstanzen und der Umhüllung mit Isolierstoff behandelten Teile anhand eines einzelnen Systemträgers erläutert.

Damit keine Kurzschlüsse zwischen den einzelnen Leitungen 24 oder Überbrückungen der einzelnen Bauelemente erfolgen, wird das derart vorbehandelte Metallblechband 36 einem weiteren Stanzwerkzeug zugeführt, bei dem aus den Metallstreifen 42 diejenigen Teile 44 entfernt werden, die vorher zum Zusammenhalt des gestanzten Metallblechbandes 36, nicht aber nachher für die Verschaltung der elektrischen Bauelemente im späteren Bild der Leitungen 24 des Systemträgers 22 notwendig sind, und bei dem ferner im Isolierstoff im Bereich der Kontaktlöcher 43 Öffnungen 45 erzeugt werden. Die die Kontaktlöcher 43 umgebenden Teile der Metallstreifen 42 werden bei diesem Stanzvorgang zur unteren Oberflächenseite 48 der Isolierstoffumhüllung 23 gedrückt.

Dieses zur unteren Oberflächenseite 48 notwendige Versetzen der die Kontaktlöcher 43 umgebenden Teile der Metallstreifen 42 kann auch schon zusammen beim Ausstanzen der Anordnungen 41 aus dem Metallblechband 36 erfolgen.

In jedem Fall soll gewährleistet sein, daß die Leitungen 24 in den Isolierstoff der Isolierstoffumhüllung 23 eingebettet sind und nur an den für die Verlötung mit den Stromzuführungsdrähten 51 der Bauelemente erforderlichen Oberflächenteilen für den Lötvorgang zugänglich sind.

In FIG 6, die einen vergrößerten Schnitt längs der Lini VI - VI in FIG 5 darstellt, ist dies schematisch verdeutlicht. Der in die Öffnung 45 hineinragende Metallstreifen 42 ist zur unteren Oberflächenseite 48 der Isolierstoffumhüllung 23 umgebogen, so daß dort ein Lötvorgang möglich ist, wie dies in FIG 9 dargestellt ist.

Um das Entfernen der Teile 44 der Metallstreifen 42 zu erleichtern, ist es vorteilhaft, von einer oder von beiden Oberflächenseiten 48 und/oder 49 Vertiefungen 50 vorzusehen, die der Länge des zu entfernenden Teiles 44 entsprechen, jedoch etwas breiter als die Metallstreifen 42 sind. Der Stanzvorgang ist dann an diesen Stellen besonders einfach durchzuführen.

FIG 7 zeigt einen Blick auf die obere Oberflächenseite 49 des Systemträgers 22 nach dem Entfernen der Teile 44 und dem Herstellen der Öffnungen 45 in der Isolierstoffumhüllung 23. Die Vertiefungen 50 reichen nunmehr von der oberen Oberflächenseite 49 zur unteren Oberflächenseite 48 des Systemträgers 22 und stellen eine Isolierstrecke dar. Sollte diese Luftstrecke für besonders hohe Anforderungen als Isolierung nicht ausreichen, so können die Vertiefungen 50 mit Isolierstoff ausgefüllt werden, wobei dieser Isolierstoff ein im Hohlraum des Griffes 20 befestigter Steg sein kann, wie dies oben schon erläutert ist.

In FIG 7 ist auch die eingebettete Leitung 34 gezeigt, die vom Lötpunkt 33 zu einem Lötpunkt für die Verbindung mit einem Stromzuführungsdraht der Glimmlampe reicht. Das in FIG 3 gezeigte Kabel 31, das den Lötpunkt 33 mit der Anschlußfahne 29 verbindet, kann auch durch eine ebenfalls gestanzte Leitungsverbindung ersetzt sein.

Man erkennt in FIG 7 sehr deutlich die besonders einfache Möglichkeit der Verschaltung, die aus der einfachen Schaltungsanordnung gemäß FIG 1 resultiert.

Am oberen Rand des Systemträgers 22 sind in FIG 7 Einkerbungen 53 zu sehen, durch die ebenfalls eine Unterbrechung der Leitungen 24 erfolgt.

FIG 8 zeigt schematisch den Spannungstester als aus den Griffen 19 und 20 bestehendes Gerät, die miteinander durch das Leitungskabel 21 verbunden sind. Im Griff 19 ist der Strombegrenzungswiderstand 18 gezeigt.

Die schematische Darstellung des Spannungstesters bedingt, daß beim Griff 20 das Gehäuse weggelassen ist, so daß in Draufsicht die einzelnen elektrischen Bauelemente 3 bis 17 und das vom Lötpunkt 32 zum Lötpunkt 33 verlaufende Leitungskabel 31 zu sehen ist. Auch FIG 8 zeigt den besonders einfachen Aufbau des Spannungstesters.

FIG 9 zeigt den Ausschnitt IX in FIG 3 und ist ein Schnitt längs den Linien IX - IX in den FIG 7 und 8. Es ist dargestellt, wie die Stromzuführungsdrähte 51 durch die Lötstellen 25 mit den Leitungen 24 verbunden sind.

In FIG 7 ist zu erkennen, daß im rechten Bereich des Systemträgers 22 in den Leitungen 24 mehr Öffnungen für das Einführen von Stromzuführungsdrähten vorhanden sind als nachher für den Einsatz der Vorwiderstände 6, 7, 16, 17 und 13, 14 erforderlich sind. Dies hat den Zweck, daß eine gewisse Variationsbreite für die Länge der einzelnen Widerstände möglich ist.

In FIG 9 ist auch zu erkennen, daß die Leitungen 24 in die Isolierstoffumhüllung 23 eingebettet sind und nur im Bereich der Öffnungen 45 zur Oberflächenseite 48 reichen. Die durchgehende Vertiefung 50 stellt eine Luftstrecke zwischen den Resten der Leitung 24 dar. Falls, wie oben bereits erläutert, die Isolation durch diese Luftstrecke nicht ausreichend ist, kann die Vertiefung 50 mit Isolierstoff 54 ausgefüllt sein.

Bezugszeichenliste und Ausführungsbeispiel
8 Patentansprüche
9 Figuren

Bezugszeichenliste und Ausführungsbeispiel

I erste Reihenschaltung       für 4,5 V, insb. 6 V und mehr
II zweite Reihenschaltung      für 40 V, insb. 50 V und mehr
III dritte Reihenschaltung     für 110 V, insb. 120 V und mehr
1 Prüfspitze
2 Prüfspitze
3 erster Kaltleiter (PTC-Widerstand)       3,2 bis 4,6 kOhm bei Nenntemperatur
4 Leuchtdiode LED1     für 6 V
5 Leuchtdiode LED2     für 6 V
6 Vorwiderstand     1 kOhm bei 1 W
7 Vorwiderstand     1 kOhm bei 1 W
8 zweiter Kaltleiter (PTC-Widerstand)      3,2 bis 4,6 kOhm bei Nenntemperatur
9 Leuchtdiode LED3     für 50 V
10 Leuchtdiode LED4     für 50 V
11 Zenerdiode       Durchbruchspannung 36 bis 40 V
12 Zenerdiode     Durchbruchspannung 36 bis 40 V
13 Vorwiderstand      1 kOhm bei 1 W
14 Vorwiderstand      1 kOhm bei 1 W
15 Glimmlampe GL      120 V
16 Vorwiderstand      75 kOhm bei 1 W
17 Vorwiderstand      75 kOhm bei 1 W
18 Strombegrenzungswiderstand       220 Ohm bei 1 W
19 Griff
20 Griff
21 Verbindungskabel
22 Systemträger
23 Isolierstoffumhüllung
24 Leitungen
25 Lötstellen
26 Aufsatz
27 runde Ausnehmungen
28 längliche Ausnehmung
29 Anschlußfahne
30 Anschlußfahne
31 Leitungskabel
32 Lötpunkt
33 Lötpunkt
34 eingebettete Verbindungsleitung
35 Öffnungen im Griff 20 für die optischen Anzeigenelemente
36 Metallblechband, 0,1 bis 1,0 mm, vorzugsweise 0,3 mm, dick

37 Breite des Metallblechbandes 36

38 Zwischenräume

39 Restverbindungen

40 verbleibende Randstreifen

41 Anordnung

42 Metallstreifen

43 Kontaktlöcher

44 Teile der Metallstreifen 42, die zu entfernen sind

45 Öffnungen im Isolierstoff im Bereich der Kontaktlöcher

46 vorderes Ende des Systemträgers 22

47 hinteres Ende des Systemträgers 22

48 untere Oberflächenseite der Isolierstoffumhüllung

49 obere Oberflächenseite der Isolierstoffumhüllung

50 Vertiefungen von einer oder von beiden Oberflächenseiten

51 Stromzuführungsdrähte

52 Löcher im Randstreifen 40

53 Einkerbungen

54 Isolierstoff

## Ansprüche

1. Spannungstester zur gestaffelten optischen Anzeige der an Prüfspitzen (1, 2) anliegenden Spannung (U) mit einer Schaltungsanordnung der elektrischen Bauelemente, die eine erste Reihenschaltung (I) aus einem ersten Kaltleiter (PTC-Widerstand) (3), zwei antiparallel geschalteten Leuchtdioden (4, 5) und wenigstens einem Vorwiderstand (6, 7) enthält, die so abgestimmt ist, daß bei einer Spannung (U) an den Prüfspitzen (1, 2), die 4,5 Volt, insbesondere 6 Volt, übersteigt, eine oder beide Leuchtdioden (4, 5) aufleuchten, **gekennzeichnet** durch die weiteren Merkmale:

- parallel zur ersten Reihenschaltung (I) ist wenigstens eine zweite Reihenschaltung (II) aus einem zweiten Kaltleiter (8), zwei antiparallel geschalteten Leuchtdioden (9, 10), zwei in Reihe liegenden, jedoch gegeneinander gepolten Zenerdioden (11, 12) und wenigstens einem Vorwiderstand geschaltet, die so abgestimmt ist, daß bei einer Spannung (U) an den Prüfspitzen (1, 2), die 40 Volt, insbesondere 50 Volt, übersteigt, eine oder beide Leuchtdioden (9, 10) aufleuchten;

- parallel zur ersten Reihenschaltung (I) und zur wenigstens einen zweiten Reihenschaltung (II) ist eine dritte Reihenschaltung (III) aus einer Glimmlampe (15) und wenigstens einem Vorwiderstand (16, 17) geschaltet, die so abgestimmt ist, daß bei einer Spannung (U) an den Prüfspitzen (1, 2), die 110 Volt, insbesondere 120 Volt, übersteigt, die Glimmlampe (15) aufleuchtet;

- in Reihe zu den drei Reihenschaltungen (I, II, III) ist ein Strombegrenzungswiderstand (18) geschaltet.

2. Spannungstester nach Anspruch 1, **gekennzeichnet** durch folgende Merkmale:

- in der ersten Reihenschaltung (I) weist der erste Kaltleiter (3) einen Widerstandswert von 3,2 bis 4,6 kOhm auf, die Leuchtdioden (4, 5) sind für das Aufleuchten bei 4,5 V, insbesondere 6 V, ausgelegt und es sind zwei Vorwiderstände (6, 7) vorhanden, die je einen Widerstandswert von 1 kOhm bei einer Leistung von 1 W aufweisen;

- in der zweiten Reihenschaltung (II) weist der zweite Kaltleiter (8) einen Widerstandswert von 3,2 bis 4,6 kOhm auf, die Leuchtdioden (9, 10) sind für das Aufleuchten bei 40 V, insbesondere 50 V, ausgelegt, es sind zwei Vorwiderstände (13, 14) vorhanden, die je einen Widerstandswert von 1 kOhm bei einer Leistung von 1 W aufweisen und die beiden Zenerdioden (11, 12) haben eine Durchbruchspannung von 35 bis 40 Volt;

- in der dritten Reihenschaltung (III) sind zwei Vorwiderstände (16, 17) vorhanden, die je einen Widerstandswert von 75 kOhm bei einer Leistung von 1 W aufweisen und die Glimmlampe (15) ist für das Aufleuchten bei 110 V, insbesondere 120 V, ausgelegt;

- der Strombegrenzungswiderstand (18) weist einen Widerstandswert von 220 Ohm bei einer Leistung von 1 W auf.

3. Spannungstester nach Anspruch 1, bei dem die einzelnen elektrischen und mit Stromzuführungsdrähten versehenen Bauelemente der gesamten Schaltungsanordnung in einem aus zwei Griffen (19, 20) bestehenden Gerät untergebracht sind, die durch ein Verbindungskabel (21) miteinander verbunden sind, Prüfspitzen (1, 2) aufweisen und Öffnungen (35) enthalten, durch die hindurch die zur optischen Anzeige dienenden Bauelemente beobachtet werden können, **gekennzeichnet** durch die Merkmale:

- der Strombegrenzungswiderstand (18) ist in einem Griff (19) untergebracht;

- die restlichen elektrischen Bauelemente ( 3 bis 17) der drei Reihenschaltungen (I, II, III) sind im anderen Griff (20) untergebracht, befinden sich dort auf einem dem Hohlraum des Griffes (20) angepaßten Systemträger (22) und sind miteinander durch aus Metallblech bestehende Leitungen (24) elektrisch leitend verbunden;

- der Systemträger (22) besteht aus einer einstückigen, längsgestreckten Isolierstoffumhüllung (23), in der die die Bauelemente (3 bis 17) verbindenden Leitungen (24) derart ein gebettet sind, daß sie nur an Lötstellen (25) die untere Oberflächenseite (48) der Isolierstoffumhüllung (23) durchstoßen;

- die Isolierstoffumhüllung (23) ist einstückig mit einem Aufsatz (26) versehen, der runde Ausnehmungen (27), in denen die Leuchtdioden (4, 5, 9, 10) untergebracht sind, und eine längliche Ausnehmung (28), in der die Glimmlampe (15) untergebracht ist, enthält;

- der Systemträger (22) weist an den gegenüberliegenden Enden (46, 47) Anschlußfahnen (29, 30) auf, die aus der Isolierstoffumhüllung (23) herausragen, mit denen im Inneren der Isolierstoffumhüllung (23) die Schaltungsanordnung des zweiten Griffes (20) verschaltet ist und von denen eine Anschlußfahne (29) mit der Prüfspitze (1) und die andere Anschlußfahne (30) mit dem Verbindungskabel (21) verbunden ist.

4. Spannungstester nach Anspruch 3, **dadurch gekennzeichnet,** daß ein Leitungskabel (31) vorhanden ist, durch das die Glimmlampe (15) mit der Anschlußfahne (29) verbunden ist und das von einem Lötpunkt (32) der Anschlußfahne (29) ausgehend an dem Aufsatz (26) der Isolierstoffumhüllung (23) entlanggeführt zu einem Lötpunkt (33) einer eingebetteten Verbindungsleitung (34) verläuft, die mit einem Pol der Glimmlampe (15) verbunden ist.

5. Spannungstester nach Anspruch 3, **dadurch gekennzeichnet,** daß die Bauelemente (3 bis 17) auf der oberen Oberflächenseite (49) des Systemträgers (22) wie folgt angeordnet sind:
- die beiden Kaltleiter (3, 4) befinden sich in Längsrichtung des Systemträgers (22) an seinem vorderen Ende (46) parallel zueinander;
- zwischen den beiden Kaltleitern (3, 4) beginnt das Leitungskabel (31), verläuft dann entsprechend oft rechtwinklig abgebogen an der Außenseite des Aufsatzes (26) zu einem Lötpunkt (33);
- die Leuchtdioden (5, 6, 9, 10) sind in einer Reihe in Längsrichtung des Systemträgers (22) und in dessen Mitte in den runden Ausnehmungen (27) des Aufsatzes (26) untergebracht;
- die Glimmlampe (15) befindet sich in der länglichen Ausnehmung (28) des Aufsatzes (26) anschließend an die letzte der Leuchtdioden (10);
- die Zenerdioden (11, 12) sind im Anschluß an die Glimmlampe (15) quer zur Längsrichtung des Systemträgers (22) angeordnet;
- die Vorwiderstände (6, 7) der ersten Reihenschaltung (I) sind hintereinander und in Längsrichtung des Systemträgers (22) in Nachbarschaft zu einem Rand der Oberflächenseite (49) angeordnet;
- die Vorwiderstände (13, 14) der zweiten Reihenschaltung (II) sind parallel zu den Vorwiderständen (6, 7) der ersten Reihenschaltung (I) in Nachbarschaft zum anderen Rand der Oberflächenseite (49) angeordnet;
- die Vorwiderstände (16, 17) der dritten Reihenschaltung (III) sind parallel zu den anderen Vorwiderständen (6, 7, 13, 14) und zwischen denselben angeordnet.

6. Verfahren zur Herstellung eines Spannungstesters nach Anspruch 3, **gekennzeichnet** durch die nachfolgenden Verfahrensschritte in dieser oder in einer entsprechenden Reihenfolge:

a) aus einem mit einer lötfähigen Schicht überzogenen, 0,1 bis 1,0 mm dicken Metallblechband (36) beliebiger Länge und einer Breite (37), die größer als das ganzzahlige Ein- bis Fünffache der Länge eines Systemträgers (22) samt Anschlußfahnen (29, 30) ist, werden sämtliche Zwischenräume (38) zwischen Restverbindungen (39) verbleibender Randstreifen (40) des Metallblechbandes (36) und einer Anordnung (41) aus Metallstreifen (42) und zwischen diesen Metallstreifen (42) derart herausgestanzt, daß die Metallstreifen (42) dieser Anordnung (41) dem späteren Bild der Leitungen (24) des Systemträgers (22) entsprechen und Kontaktlöcher (43) für die Stromzuführungsdrähte (51) der Bauelemente (3 bis 17) aufweisen;

b) das ausgestanzte selbsttragende Metallblechband (36) wird einem Werkzeug zur Spritzguß- oder Gießformumhüllung zugeführt, wo jede der Anordnungen (41) zumindest einzeln in Isolierstoff eingebettet wird, der nach der Aushärtung die Isolierstoffumhüllung (23) mit dem Aufsatz (26) bildet, wobei die Anschlußfahnen (29, 30) an den Enden (46, 47) herausragen;

c) das derart vorbehandelte Metallblechband (36) wird einem weiteren Stanzwerkzeug zugeführt, bei dem aus den Metallstreifen (42) diejenigen Teile (44) entfernt werden, die vorher zum Zusammenhalt des gestanzten Metallblechbandes (36), nicht aber nachher für die Verschaltung der elektrischen Bauelemente im späteren Bild der Leitung (24) des Systemträgers (22) notwendig sind, und bei dem ferner in der Isolierstoffumhüllung (23) im Bereich der Kontaktlöcher (43) Öffnungen (45) erzeugt werden und die die Kontaktlöcher (43) umgebenden Teile der Metallstreifen (42) zur unteren Oberflächenseite (48) der Isolierstoffumhüllung (23) gedrückt werden;

d) vor oder nach dem Vereinzeln der Systemträger (22) werden diese mit den elektrischen Bauelementen (3 bis 17) bestückt, die an der unteren Oberflächenseite (48) durch Schwall- oder Tauchlötung mit den Leitungen (24) elektrisch leitend und mechanisch verbunden werden;

e) jeder Systemträger (22) wird in dem Hohlraum eines Griffes (20) untergebracht, vorher oder danach werden die Anschlußfahnen (29, 30) mit der Prüfspitze (1) bzw. mit dem Verbindungskabel (21), das bereits am anderen Griff (19) angebracht ist und den Strombegrenzungswiderstand (18) enthält, verbunden, wonach der Griff (20) verschlossen wird.

7. Verfahren nach Anspruch 6, **dadurch gekennzeichnet,** daß die im Verfahrensschritt c) vorgesehene Maßnahme, bei der die die Kontaktlöcher (43) umgebenden Teile der Metallstreifen (42) aus deren Ebene heraus in Richtung der unteren Oberflächenseite (48) der Isolierstoffumhüllung (23) gedrückt werden, bereits im Verfahrensschritt a) zusammen mit dem dortigen Stanzvorgang durchgeführt wird.

8. Verfahren nach Anspruch 7, **dadurch gekennzeichnet,** daß im Verfahrensschritt b) bei der Herstellung der Isolierstoffumhüllung (23) in der Spritzgußform oder in der Gießform Erhebungen vorgesehen sind derart, daß sowohl die Öffnungen (45) im Bereich der Kontaktlöcher (43) als auch von einer oder von beiden Oberflächenseiten (48, 49) der Isolierstoffumhüllung (23) aus Vertiefungen (50) entstehen, die bis zu den zu entfernenden Teilen (44) der Metallstreifen (42) reichen.

FIG 1

FIG 2

FIG 3

FIG 4

FIG 5

FIG 6

FIG 7

# FIG 8

# FIG 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-2 830 323 (LAUERER) * Seiten 5-7; Figur 8 * | 1,2 | G 01 R 19/14 |
| Y | DE-A-2 524 084 (SIEMENS) * Seite 3, Absatz 4 * | 1,2 | |
| A | CH-A- 601 801 (LOGAR) * Figur 5; Spalten 3,4 * | 1-8 | |
| D,A | FR-A-2 388 281 (SIEMENS) * Seite 10 * | 3,6 | |
| D,A | DE-A-2 060 884 (SIEMENS) | | |
| D,A | EP-A-0 011 711 (SIEMENS) | | |
| D,A | EP-A-0 068 501 (SIEMENS) | | |

RECHERCHIERTE SACHGEBIETE (Int. Cl.4)

G 01 R

Der vorliegende Recherchenbericht wurde für alle Patentansprüche erstellt

| Recherchenort | Abschlußdatum der Recherche | Prüfer |
|---|---|---|
| DEN HAAG | 27-04-1989 | HOORNAERT W. |